# EUROPÄISCHE PATENTANMELDUNG

(11) **EP 4 482 275 A1**
(43) Veröffentlichungstag der Anmeldung: **25.12.2024**
(21) Anmeldenummer: 24183374.8
(22) Anmeldetag: 20.06.2024
(51) Int. Cl.: H10K 30/81, H10K 39/12, H10K 71/20

(54) **VERFAHREN ZUR HERSTELLUNG EINES HALBLEITERELEMENTS, HALBLEITERELEMENT UND ANLAGE**

(30) Priorität: 21.06.2023 DE 102023205829
(71) Anmelder: ASCA GmbH & Co. KG, 97318 Kitzingen (DE)
(72) Erfinder: GREBNER, Manuel, 96050 Bamberg (DE); MEIER, Sebastian, 91090 Effeltrich (DE); NUNES DOMSCHKE, Tamara, 97340 Marktbreit (DE); SAUERMANN, Tobias, 90762 Fürth (DE); SCHILINSKY, Pavel, 28279 Bremen (DE); SCHINDLER, Stefan, 90341 Nürnberg (DE)
(74) Vertreter: FDST Patentanwälte

(57) **Zusammenfassung**

Es wird ein Verfahren zur Herstellung eines Halbleiterelements (2), insbesondere eines organischen Photovoltaikelements, angegeben, welches eine untere Elektrode (4), eine aktive Schicht (6) und eine obere Elektrode aufweist (8), wobei ein Halbzeug (14) bereitgestellt wird, welches die untere Elektrode (4) aufweist sowie die aktive Schicht (6), welche auf die untere Elektrode (4) aufgetragen ist, wobei ein oder mehrere Trennstellen vorgegeben sind oder werden, wobei die untere Elektrode (4) durch die aktive Schicht (6) hindurch strukturiert wird und dabei an den Positionen für die rennstellen (22) jeweils eine Unterbrechung (24) als Trennstelle (22) ausgebildet wird, welche die untere Elektrode (4) in mehrere untere Teilelektroden (26) unterteilt, wobei an den Trennstellen (22) ein Sperrmaterial (28) aufgedruckt wird, um eine Kontaktierung der unteren Elektrode (4) mit der oberen Elektrode (8) an den Trennstellen (22) zu verhindern, wobei die obere Elektrode (8) auf die aktive Schicht (6) aufgedruckt wird. Weiter werden ein entsprechendes Halbleiterelement (2) angegeben sowie eine Anlage zur Durchführung des Verfahrens.

## Beschreibung

Die Erfindung betrifft Verfahren zur Herstellung eines Halbleiterelements sowie ein solches Halbleiterelement und eine Anlage zur Durchführung des Verfahrens. Das Halbleiterelement ist vorzugsweise ein organisches Photovoltaikelement.

Ein Halbleiterelement ist allgemein eine Schichtstruktur, mit einer oberen Elektrode und einer unteren Elektrode sowie mit einer aktiven Schicht, welche zwischen den Elektroden angeordnet ist. Die aktive Schicht ist aus einem oder mehreren organischen Halbleitermaterialien hergestellt, die Elektroden dienen zur Ab- oder Zufuhr von Strom in oder aus der aktiven Schicht. Speziell bei einem Photovoltaikelement wird Energie durch Umwandlung von Licht erzeugt, welches in der aktiven Schicht absorbiert wird. Dabei werden in der aktiven Schicht Ladungen freigesetzt und somit ein Strom erzeugt, welcher über die Elektroden abgeführt wird. Typischerweise weist die Schichtstruktur auch ein Substrat auf, auf welchem die Elektroden und die aktive Schicht aufgebracht sind und welches regelmäßig deutlich dicker ist als die Elektroden und die aktive Schicht.

Speziell für organische Photovoltaikelemente, aber auch ganz allgemein für organische Halbleitermodule, ist ein möglichst flexibles Herstellungsverfahren wünschenswert, um einerseits die Herstellungskosten möglichst gering zu halten und um andererseits die Gestaltungsmöglichkeiten bei der Herstellung möglichst vollumfänglich und kostengünstig nutzen zu können. Auch ist es wünschenswert, die Herstellung organischer Halbleitermodule hin zu größeren Fertigungsvolumina zu skalieren ohne dabei Gestaltungsmöglichkeiten aufgeben zu müssen.

In der US 4,243,432 ist eine Anordnung von photovoltaischen Zellen beschrieben, welche untereinander mit Durchkontaktierungen in geeigneter Weise verbunden sind. Die Zellen werden hergestellt, indem mehrere Schichten, darunter auch anorganische Halbleiterschichten, auf einem transparenten Substrat gebildet werden und dann Teile der Schichten selektiv entfernt werden. Dadurch werden freigelegte Streifen gebildet. Sobald eine Vielzahl von Zellen gebildet und elektrisch voneinander isoliert ist, müssen diese verbunden werden, um eine Serienschaltung der Zellen zu bilden. Die Kanten der Halbleiterschichten an den Rändern der freigelegten Streifen werden zuerst mit elektrisch isolierenden Materialien beschichtet, nämlich mit einem filmbildenden Material, welches bei Maskierungsvorgängen für chemisches Ätzen verwendet wird. Schließlich wird ein leitendes Material aufgebracht, um die Photovoltaikzellen zu einem Array zu verbinden.

In der DE 10 2017 209 226 A1 wird ein Verfahren zur Herstellung eines organischen Photovoltaikelements beschrieben. Dabei wird eine aktive Schicht auf eine untere Elektrode aufgetragen. Die untere Elektrode wird dann strukturiert, wobei eine Anzahl von Trennstellen ausgebildet wird. An den Trennstellen wird ein Sperrmaterial aufgetragen, welches eine Kontaktierung einer späteren oberen Elektrode mit der unteren Elektrode an den Trennstellen verhindert. Außerdem wird die aktive Schicht derart strukturiert, dass eine Anzahl an Kontaktstellen ausgebildet wird, an welchen die untere Elektrode freigelegt wird. Schließlich wird auf die aktive Schicht eine obere Elektrode aufgetragen und diese an einer jeweiligen Kontaktstelle mit der unteren Elektrode kontaktiert.

In der DE 10 2014 213 978 A1 wird ein Verfahren zur Herstellung eines organischen Halbleiterbauteils mit einer aktiven Schicht beschrieben. Zur Ausbildung von Durchkontaktierungen wird in einem vorgegebenen Druckbereich eine Tinte aufgedruckt. Die Tinte wird entweder vor einem Auftragen der aktiven Schicht aufgedruckt und verdrängt diese dann oder die Tinte enthält ein Lösungsmittel und durchdringt die zuvor bereits aufgebrachte aktive Schicht.

Vor diesem Hintergrund ist es eine Aufgabe der Erfindung, ein möglichst flexibles und zugleich möglichst großvolumiges Herstellungsverfahren für organische Halbleiterelemente, speziell Photovoltaikelemente, anzugeben. Weiterhin soll ein entsprechendes Halbleiterelement angegeben werden.

Die Aufgabe wird erfindungsgemäß gelöst durch ein Verfahren mit den Merkmalen gemäß Anspruch 1, durch ein Halbleiterelement mit den Merkmalen gemäß Anspruch 14 sowie durch ein Verfahren mit den Merkmalen gemäß Anspruch 15. Das Halbleiterelement ist vorzugsweise mittels des Verfahrens hergestellt. Vorteilhafte Ausgestaltungen, Weiterbildungen und Varianten sind Gegenstand der Unteransprüche. Die Ausführungen im Zusammenhang mit dem Verfahren gelten sinngemäß auch für das Hableiterelement und die Anlage sowie umgekehrt. Sofern nachfolgend Schritte des Verfahrens implizit oder explizit beschrieben sind, ergeben sich vorteilhafte Ausgestaltungen für die Anlage dadurch, dass diese ausgebildet ist einen oder mehrere dieser Schritte durchzuführen.

Die Erfindung basiert insbesondere auf den folgenden beiden Kerngedanken. Zum einen wird im Herstellungsverfahren die Erforderlichkeit und das Einbringen einer Designentscheidung bezüglich der konkreten Ausgestaltung des Halbleiterelements möglichst weit nach hinten verlagert, sodass weitestgehend vorbereitete Halbzeuge verwendet und vorgehalten werden können und dann schnell und flexibel in einem konkreten Auftrag verarbeitet werden können, um eine bestimmte Designentscheidung umzusetzen. Zum anderen werden bei der Herstellung soweit wie möglich leicht skalierbare und gleichzeitig flexible Druckverfahren verwendet, speziell zur Umsetzung der Designentscheidung, d.h. eines individuellen Auftrags, ausgehend von einem Halbzeug.

Das erfindungsgemäße Verfahren dient zur Herstellung eines Halbleiterelements, insbesondere eines organischen Halbleiterelements und/oder Dünnschicht-Halbleiterelements, bevorzugterweise eines organischen Photovoltaikelements und/oder Dünnschicht-Photovoltaikelements. Geeignete Photovoltaikelemente sind insbesondere Perowskit-Photovoltaikelemente, CIGS- Photovoltaikelemente oder Dünnschicht-Si-Photovoltaikelemente. Unter "Dünnschicht" wird insbesondere ein Halbleiterelement verstanden, welches eine aktive Schicht mit einer Dicke von weniger als 10 µm oder sogar weniger als 1 µm aufweist. Nachfolgend wird ohne Beschränkung der Allgemeinheit von der Herstellung eines organischen Dünnschicht-Photovoltaikelements ausgegangen, für welches das Verfahren auch besonders geeignet ist.

Das Halbleiterelement weist eine untere Elektrode, eine aktive Schicht und eine obere Elektrode auf. Diese bilden insbesondere zusammen mit einem Substrat eine Schichtstruktur. Im Rahmen des Verfahrens werden die untere Elektrode, die aktive Schicht und die obere Elektrode geeignet strukturiert ausgebildet und die Elektroden miteinander verbunden, um mehrere Zellen auszubilden, welche elektrisch miteinander verschaltet sind. Die genaue Form, Größe und Verschaltung der Zellen ist insbesondere durch eine Designentscheidung vorgegeben. Mit dem hier beschriebenen Verfahren sind unterschiedlichste Designentscheidung flexibel und mit besonders geringem Aufwand umsetzbar.

In einem ersten Schritt des Verfahrens wird ein Halbzeug bereitgestellt, welches die untere Elektrode sowie die aktive Schicht aufweist, welche auf die untere Elektrode aufgetragen ist. Dabei sind die untere Elektrode und die aktive Schicht jeweils insbesondere unstrukturiert und vorzugsweise vollflächig ausgebildet. Insbesondere ist bei dem Halbzeug noch keine Designentscheidung getroffen worden oder zumindest noch nicht notwendig und in dessen Herstellung jedenfalls nicht eingeflossen.

Allgemein wird das Verfahren auf einer entsprechenden Anlage ausgeführt, in welche das Halbzeug eingegeben wird und welche dann das fertige Halbleiterelement (typischerweise mehrere Halbleiterelemente) ausgibt. Die Anlage weist allgemein eine Förderrichtung auf, in welcher das Halbzeug durch die Anlage gefördert wird. Das Halbzeug wird vorzugsweise in aufgerollter Form, d.h. als aufgerollte Materialbahn und als Rolle, bereitgestellt, welche dann im Rahmen des Verfahrens abgerollt und wie nachfolgend beschrieben weiterverarbeitet wird, sodass das Verfahren dann ein Rollenverarbeitungsverfahren ist. Alternativ werden auch die untere Elektrode oder die aktive Schicht oder beide erst in der Anlage aufgedruckt, dann jedoch vorzugsweise jeweils zunächst vollflächig. Am Ende des Verfahrens wird die Materialbahn beispielsweise wieder aufgerollt (Rolle-zu-Rolle) oder zusätzlich konfektioniert (Rolle-zu-Stück), z.B. zu mehreren einzelnen Halbleiterelementen vereinzelt, welche vorzugsweise jeweils noch zusätzlich in eine Schutzhülle eingekapselt werden. Die Vereinzelung erfolgt insbesondere erst nachdem sämtliche Strukturierungsschritte und sämtliche Druckschritte ausgeführt wurden, d.h. die nachfolgend beschriebene Verarbeitung (Strukturierung und Bedrucken) des Halbzeugs erfolgt in Bahnform und vor einer Vereinzelung.

Die untere Elektrode weist vorzugsweise eine Schichtdicke im Bereich von 10 nm bis 10µm auf. Das Substrat besteht geeigneterweise aus einem transparenten Kunststoff, z.B. PET. Das Substrat dient insbesondere als robuste Unterlage bei der Fertigung des Halbleiterelements und weist vorzugsweise eine Schichtdicke im Bereich von 10 µm bis 500 µm auf. Die untere Elektrode ist auf das Substrat beispielsweise aufgesputtert und geeigneterweise aus einem transparenten, leitenden Material hergestellt, z.B. ITO. Die aktive Schicht ist dann auf die untere Elektrode aufgetragen und wird insbesondere aus mehreren, z.B. zwei Einzelschichten gefertigt, welche jeweils aus einem aktiven Material bestehen, z.B. eine erste Einzelschicht aus P3HT und eine zweite Einzelschicht aus PCBM oder eine Abfolge von Elektron-Transportschicht(en), Bulkheterojunction und Loch-Transportschicht(en).

Es sind oder werden ein oder mehrere Positionen für Trennstellen vorgegeben, entweder als Teil des Verfahrens oder außerhalb davon. In einer möglichen Ausgestaltung werden die Positionen für die Trennstellen sogar erst nach dem ersten Schritt vorgegeben. Für jede Trennstelle wird genau eine Position vorgegeben. Damit ist festgelegt an welchen Positionen des Halbleiterelements Trennstellen liegen sollen. An diesen Positionen erfolgt dann nachfolgend eine spezielle Bearbeitung. Nachfolgend wird ohne Beschränkung der Allgemeinheit davon ausgegangen, dass mehrere Positionen für Trennstellen vorgegeben sind oder werden und das entsprechend mehrere Trennstellen ausgebildet werden.

In einem zweiten Schritt des Verfahrens (vorzugsweise nach dem ersten Schritt) wird die untere Elektrode durch die aktive Schicht hindurch strukturiert und dabei wird an den Positionen für die Trennstellen je eine Unterbrechung als Trennstelle ausgebildet, welche die untere Elektrode in mehrere untere Teilelektroden unterteilt. An den vorgegebenen Positionen werden demnach tatsächliche Trennstellen ausgebildet. Mit anderen Worten: in der unteren Elektrode und in der aktiven Schicht wird an einer der vorgegebenen Positionen als jeweilige Trennstelle eine Unterbrechung erzeugt. Im zweiten Schritt erfolgt demnach eine Strukturierung der unteren Elektrode. Der zweite Schritt enthält somit einen P1*-Strukturierungsschritt. Diese Strukturierung wird auch als P1*-Strukturierung bezeichnet und erfolgt mittels einer (ersten) Strukturierungseinheit der Anlage. Die genaue Lage der Trennstellen ist Teil einer Designentscheidung für das Halbleiterelement, d.h. der Strukturierung liegt eine konkrete Designentscheidung hinsichtlich einer Verschaltung, Form und/oder Größe der Zellen des herzustellenden Halbleiterelements zugrunde. Die Designentscheidung enthält insbesondere die Positionen für die Trennstellen. Mit der P1*-Strukturierung werden insbesondere Form, Größe und relative Anordnung der Zellen des Halbleitermoduls festgelegt. Die P1 *-Strukturierung ist insbesondere der erste Zeitpunkt im Verfahren, zu welchem eine Designentscheidung vorliegen muss. Durch die Verwendung des Halbzeugs liegt dieser Zeitpunkt besonders weit hinten im Herstellungsverfahren.

Die untere Elektrode (und damit auch die aktive Schicht) wird vorzugsweise derart strukturiert, dass an einer jeweiligen Trennstelle ein Graben ausgebildet ist, welcher insbesondere beidseitig durch nunmehr voneinander getrennte Teilbereiche der unteren Elektrode und der aktiven Schicht berandet ist. Der Graben ist auch eine Unterbrechung sowohl der unteren Elektrode als auch der aktiven Schicht. Die Teilbereiche der unteren Elektrode entsprechen den bereits genannten Teilelektroden. Eine jeweilige Unterbrechung weist vorteilhafterweise eine Breite von maximal 200 µm auf, besonders bevorzugt von maximal 10 µm. Zweckmäßigerweise wird die untere Elektrode mit einem Laser strukturiert, d.h. die Strukturierungseinheit ist ein Laser, mit welchem die genannte, geringe Breite auf einfache Weise realisierbar ist. Durch die geringe Breite wird entsprechender Totraum reduziert.

In einem dritten Schritt (vorzugsweise nach dem ersten Schritt und nach oder vor dem zweiten Schritt) wird mit einer ersten Druckeinheit der Anlage an den Trennstellen ein Sperrmaterial aufgedruckt, um eine Kontaktierung der unteren Elektrode mit der oberen Elektrode an den Trennstellen zu verhindern. In einem vierten Schritt (vorzugsweise nach dem zweiten und/oder dritten Schritt) wird dann mit einer zweiten Druckeinheit die obere Elektrode auf die aktive Schicht aufgedruckt. Die erste und die zweite Druckeinheit können grundsätzlich auch identisch sein, sodass nur eine einzelne Druckeinheit zum Aufdrucken des Sperrmaterials und der oberen Elektrode verwendet wird, dann mittels je einem entsprechenden Druckkopf der Druckeinheit. Das Sperrmaterial ist insbesondere ein Dielektrikum oder ein Isolator und allgemein elektrisch schwach leitend oder nicht leitend. Vorzugsweise ist das Sperrmaterial ein Polymer oder ein Material auf Polymerbasis, enthält also allgemein ein Polymer, d.h. einen Kunststoff. In einer möglichen Ausgestaltung enthält das Sperrmaterial zusätzlich noch Keramik oder ein oder mehrere Metalloxide als Füllstoff.

Die oben angegebenen Schritte des Verfahrens müssen nicht zwingend in der beschriebenen Reihenfolge ausgeführt werden und zwei oder mehrere dieser Schritte können gegebenenfalls auch gleichzeitig ausgeführt werden. Insbesondere sind der zweite und dritte Schritt in beliebiger Reihenfolge oder auch gleichzeitig ausführbar.

Ein besonderer Vorteil des Verfahrens ist, dass dieses besonders flexibel ist und zugleich eine besonders großvolumige Herstellung von kundenspezifischen organischen Halbleiterelementen ermöglicht. Die entsprechend damit hergestellten Halbleiterelemente weisen geringere Herstellungskosten auf, zudem können die Gestaltungsmöglichkeiten bei der Herstellung in besonders weitem Umfang genutzt werden. Schließlich lässt sich die Herstellung besonders einfach skalieren ohne dabei Gestaltungsmöglichkeiten aufgeben zu müssen.

Von den eingangs genannten Dokumenten unterscheidet sich das hier vorgestellte Verfahren vor allem dadurch, dass das Sperrmaterial und die obere Elektrode jeweils aufgedruckt werden.

Organische Halbleitermodule können grundsätzlich in nahezu beliebiger Form und Größe hergestellt werden. Dies ist insbesondere Teil einer Designentscheidung, welche dann prinzipbedingt auch die interne Verschaltung des Halbleitermoduls betrifft. Denn ein jeweiliges Halbleitermodul soll typischerweise eine bestimmte Spannung und/oder einen bestimmten Strom liefern (oder benötigen), was eine bestimmte Verschaltung der Zellen des Halbleitermoduls miteinander erfordert. So ist beispielsweise eine Serien- oder Parallelschaltung einer bestimmten Anzahl von Zellen erforderlich. Die Dimensionierung der einzelnen Zellen ist zudem von einer oder mehreren insbesondere elektrischen Randbedingungen abhängig, z.B. sollen die Zellen möglichst gleich groß sein oder eine bestimmte Größe nicht überschreiten. In die Designentscheidung fließen zudem regelmäßig auch ästhetische Überlegungen ein, welche für das Halbleiterelement eine bestimmte Musterung oder Farbgebung fordern.

Bei der Herstellung verschiedener Halbleitermodule liegen somit je nach Auftrag unterschiedliche Designentscheidungen vor, sodass die Herstellung auf derselben Anlage je nach Auftrag umgestellt werden muss. Dies betrifft insbesondere die oben genannte Strukturierung der unteren Elektrode, analog aber auch die Herstellung der oberen Elektrode und die Strukturierung der aktiven Schicht. Um die Rüstzeit der Anlage zu minimieren und einen möglichst schnellen Wechsel zwischen unterschiedlichen Aufträgen sowie auch Print-on-Demand zu ermöglichen, ist es vorteilhaft, denjenigen Teil des Herstellungsverfahrens, welcher von der Designentscheidung zu dem jeweiligen Auftrag abhängt, zeitlich möglichst weit nach hinten zu verlagern. Auf diese Weise kann eine Vorproduktion von Halbzeugen erfolgen und die nötige Zeit zur Umsetzung eines konkreten Auftrags reduziert werden. Dies wird vorliegend dadurch realisiert, dass die P1*-Strukturierung erst erfolgt, nachdem die untere Elektrode und die aktive Schicht bereits aufgetragen wurden. Diese werden dann vorteilhaft separat hergestellt, ohne auf eine spezielle Designentscheidung zugeschnitten zu sein. Das Halbzeug wird somit typischerweise hergestellt, noch bevor die Designentscheidung feststeht. Die Erzeugung der unteren Elektrode und der aktiven Schicht entfallen somit bei der Umsetzung eines jeweiligen Auftrags, vielmehr wird von einem entsprechenden Halbzeug ausgegangen. Dies wird vorliegend auch als "late stage customization" bezeichnet, denn die Umsetzung der Designentscheidung erfolgt erst entsprechend spät im Herstellungsverfahren. Eine Strukturierung der unteren Elektrode noch bevor die aktive Schicht aufgetragen wird, würde entsprechend als "early stage customization" bezeichnet. In diesem Fall müsste die Designentscheidung spätestens vor dem Auftragen der aktiven Schicht feststehen, um zuvor noch die untere Elektrode zu strukturieren.

Aufgrund der erst nachträglichen Strukturierung der unteren Elektrode ist es zudem vorteilhaft möglich, bei der Herstellung des Halbzeugs ein sogenanntes vollflächiges Beschichtungsverfahren (d.h. "full-area coating") zu verwenden, welches insbesondere einen hohen Durchsatz aufweist und somit eine großvolumige, kostengünstige Herstellung ermöglicht. Das vollflächige Beschichtungsverfahren ist zudem insbesondere kontinuierlich und ermöglicht damit eine vorteilhaft konstante Produktion von Halbzeugen. Beispiele für ein vollflächiges Beschichtungsverfahren sind Schlitzdüsen-Beschichtung (d.h. slot-die coating") oder Sprühbeschichtung (d.h. "spray coating"). Entsprechend ist das vorliegend vorzugsweise bereitgestellte Halbzeug mittels eines solchen vollflächigen Beschichtungsverfahrens hergestellt. Dies führt insbesondere dazu, dass die untere Elektrode und die aktive Schicht vollflächig ausgebildet sind, d.h. möglichst ununterbrochen, sodass ausgehend hiervon noch jede beliebige Designentscheidung umsetzbar ist. Analog zum Aufdrucken der oberen Elektrode und des Sperrmaterials ist aber auch für die untere Elektrode und die aktive Schicht ein Digitaldruckverfahren grundsätzlich geeignet. Das Halbzeug wird in entsprechender Menge vorproduziert und vorgehalten, sodass eine Designentscheidung entsprechend kurzfristig umgesetzt werden kann.

Zusätzlich bleibt durch das Aufdrucken des Sperrmaterials und der oberen Elektrode eine maximale Gestaltungsfreiheit erhalten. Mit anderen Worten: das Sperrmaterial und die obere Elektrode werden jeweils mittels eines Druckverfahrens hergestellt. Das Druckverfahren zeichnet sich durch eine hohe Gestaltungsfreiheit aus, sodass verschiedenste, individuelle Designentscheidungen einfach und kostengünstig umgesetzt werden können. Durch die oben beschriebene Möglichkeit einer späten Designentscheidung aufgrund des flexibel einsetzbaren Halbzeugs sind so auch Klein- und Kleinstserien bis hin zu Prototypen eines Halbleiterelements besonders kostengünstig und schnell herstellbar. Durch das Aufdrucken des Sperrmaterials wird dieses zielgenau und lediglich soweit erforderlich an den Trennstellen aufgedruckt, sodass Totraum, welcher später nicht zur Funktion des Halbleiterbauteils beiträgt, weitestgehend vermieden wird. Durch das Aufdrucken der oberen Elektrode ist diese maximal frei gestaltbar.

Ganz besonders bevorzugt ist eine Ausgestaltung, bei welcher das Sperrmaterial und die obere Elektrode jeweils mittels eines Digitaldruckverfahrens aufgedruckt werden. Ein besonders bevorzugtes Digitaldruckverfahrens ist ein Inkjet-Druckverfahren (d.h. Tintenstrahldruckverfahren), die jeweilige Druckeinheit ist dann ein Inkjet-Drucker. Alternativ ist als Digitaldruckverfahren auch ein sogenanntes Dispensing-Verfahren geeignet, welches einem Inkjet-Druckverfahren grundsätzlich ähnlich ist, bei welchem das Ausbringen der Tinte jedoch auch in etwas anderer Weise über eine oder mehrere Kanülen erfolgt, aus welchen die Tinte ausgespritzt wird. Grundsätzlich ist es aber auch bereits vorteilhaft, wenn entweder das Sperrmaterial oder die obere Elektrode mittels eines Digitaldruckverfahrens aufgedruckt wird. Das Sperrmaterial und ein Material für die obere Elektrode sind dann ein Teil einer jeweiligen Tinte, welche im Rahmen des Verfahrens aufgedruckt wird. Das Digitaldruckverfahren ist insbesondere ein "drop on demand"-Verfahren. Bei dem Digitaldruckverfahrens wird eine Tinte auf Basis digitaler Bilddaten aus einem Druckkopf der Druckeinheit punktgenau und mit hoher Auflösung auf das Halbzeug auftragen wird. Damit ist ein Aufdrucken des Sperrmaterials auch bei besonders geringer Dimensionierung der P1*-Strukturierung (Breite, siehe oben), der P2- und/oder P3-Strukturierung möglich und zugleich ist auch eine besonders genaue Registrierung mit der P1*-Strukturierung möglich. Dies ist insbesondere geringer als bei einem Siebdruckverfahren oder bei Verwendung eines sogenannten "pen dispenser". Die hohe Auflösung wird insbesondere auch durch eine gegenüber anderen Druckverfahren entsprechend niedrige Viskosität der verwendeten Tinte ermöglicht. Das Digitaldruckverfahren hat also gegenüber z.B. einem Siebdruckverfahren den Vorteil, dass der Materialeinsatz geringer ist und dass geringere Toleranzen gewählt werden können, speziell für die Durchkontaktierungen, sodass die resultierenden Halbleiterelemente eine bessere Effizienz aufweisen.

Ein Digitaldruckverfahren zeichnet sich insbesondere dadurch aus, dass dieses kontaktfrei ist, d.h. die Tinte wird in Richtung des Halbzeugs ausgedüst, ein Kontakt mit dem Halbzeug besteht dabei nicht. Dadurch wird speziell beim Aufdrucken der oberen Elektrode verhindert, dass leitendes Material an ungewollter Stelle in die aktive Schicht hineingepresst wird. Speziell für organische Halbleiterelemente ergibt sich daraus der Vorteil, dass die organische, aktive Schicht deutlich dünner ausgebildet werden kann. Die aktive Schicht enthält insbesondere als eine oberste Einzelschicht (auf welche dann die obere Elektrode aufgedruckt wird) eine Lochleitungsschicht (HTL = "hole transport layer"), deren Funktionsfähigkeit durch ungewollte Partikel aus leitendem Material der oberen Elektrode signifikant beeinträchtigt wird, sodass zur Kompensation eine entsprechende Schichtdicke der Lochleitungsschicht erforderlich ist. Eine größere Schichtdicke führt aber zu schlechteren elektrischen Eigenschaften, speziell hinsichtlich Ladungsextraktion und Füllfaktor. Diese Probleme ergeben sich bei anorganischen Halbleiterelementen typischerweise nicht. Mit dem Digitaldruckverfahren kann nun die Lochleitungsschicht dünner ausgebildet werden, was hinsichtlich der elektrischen Eigenschaften vorteilhaft ist.

Ein Digitaldruckverfahren ist zudem besonders einfach konfigurierbar, speziell lässt sich an der Anlage ein Wechsel des Auftrags ohne Werkzeugwechsel und insbesondere rein softwarebasiert umsetzen, denn es genügt, lediglich die Ansteuerung der Druckköpfe an einen neuen Auftrag anzupassen. Eine Umrüstung der zur Herstellung verwendeten Anlage ist dagegen nicht erforderlich, die Rüstzeit zur Einrichtung eines neuen Auftrags ist entsprechend gering. Vielmehr weist die Anlage zum Drucken des Sperrmaterials und der oberen Elektrode wie bereits beschrieben eine oder mehrere Druckeinheiten auf, welche dann mittels entsprechender Auftragsdaten geeignet angesteuert werden, um die jeweilige Tinte je nach Auftrag individuell aufzudrucken. Die Auftragsdaten enthalten insbesondere entsprechende Bilddaten, in welchen die Designentscheidung kodiert ist und auf Basis derer dann die Druckeinheiten entsprechend angesteuert werden. Vorteilhafterweise ist die Herstellung aufgrund des Digitaldruckverfahrens auch kontinuierlich. Ein Digitaldruckverfahren bietet auch eine freie Formenwahl ("freeform") und somit eine maximale Gestaltungsfreiheit für das Halbleiterelement. Insbesondere ist auch eine Änderung des Auftrags während dessen Ausführung möglich, d.h. während der Herstellung oder "on the fly". Ein Digitaldruckverfahren ist zudem auch deutlich schneller als z.B. ein Siebdruckverfahren und ermöglicht entsprechend eine besonders hohe Fertigungsgeschwindigkeit und einen hohen Durchsatz. Das Digitaldruckverfahren ermöglicht somit auch die volle Ausnutzung des Geschwindigkeitsvorteils eines Rollenverarbeitungsverfahrens, speziell Rolle-zu-Rolle (roll-to-roll) oder Rolle-zu-Stück, was vorliegend auch bevorzugt ist. Im Gegensatz zu einem Rollenverarbeitungsverfahren steht z.B. ein Sheet-to-Sheet-Verfahren, bei welchem einzelne Halbleiterelemente oder Gruppen von Halbleiterelementen nur schrittweise nacheinander und eben nicht kontinuierlich hergestellt werden.

Als Alternative zu einem Digitaldruckverfahren sind auch andere Druckverfahren prinzipiell geeignet, z.B. Siebdruck, Tiefdruck, Flexodruck oder Transferdruck. Aus den oben genannten Gründen ist aber ein Digitaldruckverfahren besonders bevorzugt, speziell da dieses die größtmögliche Flexibilität aufweist und am einfachsten und kostengünstigsten skalierbar ist. Im Vergleich mit z.B. Siebdruck entfällt insbesondere die Notwendigkeit der Erstellung und Reinigung einer Siebdruckplatte, sodass das Digitaldruckverfahren weniger zeitintensiv ist, weniger Tinte verbraucht und somit insgesamt kostengünstiger ist.

Ein weiterer spezieller Vorteil des Digitaldruckverfahren ist, dass je nach Ausgestaltung der Druckeinheiten verschiedene Tinten vorgehalten werden können, um die Gestaltungsfreiheit weiter zu erhöhen. In einer Ausgestaltung werden für das Sperrmaterial mehrere verschiedene Tinten bereitgestellt, sodass bei der Herstellung je nach Bedarf zwischen diesen Tinten gewechselt wird. Beispielsweise weisen die Tinten verschiedene Farben auf, wodurch das Aussehen des Halbleitermoduls entsprechend mehrfarbig oder gezielt einfarbig gestaltbar ist. Gleiches gilt alternativ oder zusätzlich analog auch für die obere Elektrode und die hierzu verwendete Tinte. Alternativ oder zusätzlich werden unterschiedliche Farbkanäle einer Druckeinheit für unterschiedliche Teile des Hableitermoduls verwendet, z.B. ein erster Farbkanal für das Sperrmaterial und ein zweiter Farbkanal für die obere Elektrode. Dies führt zu einer besonders einfachen Ansteuerung der Anlage, da zur Durchführung eines Auftrags einfach Bilddaten, z.B. eine Bilddatei, verwendet werden, bei welchen ein jeweiliger Farbkanal die entsprechenden Daten zum Aufdrucken des Sperrmaterials und der oberen Elektrode enthält.

Da das Sperrmaterial möglichst wenig elektrisch leitend sein soll, die obere Elektrode dagegen möglichst gut leitend, werden konsequenterweise beim Drucken des Sperrmaterials und der oberen Elektrode verschiedene Tinten mit der entsprechend jeweils erforderlichen Eigenschaft verwendet. Die im Verfahren genutzten Bilddaten weisen entsprechend zweckmäßigerweise wenigstens zwei Farbkanäle auf. Außerdem wird die obere Elektrode erst nach dem Sperrmaterial aufgedruckt, da dieses gerade dazu dient, an den Trennstellen ein Vordringen der Tinte (welche das Material für die obere Elektrode enthält) bis zur unteren Elektrode und damit einen Kurzschluss der beiden Elektroden zu verhindern.

Dem Sperrmaterial kommt vorliegend eine besondere Bedeutung zu, da dieses die Verlagerung der Strukturierung der unteren Elektrode auf einen späteren Zeitpunkt in der Herstellung ermöglicht. Denn dadurch, dass die untere Elektrode erst strukturiert wird, nachdem die aktive Schicht schon darauf aufgetragen ist, wird bei der Strukturierung der unteren Elektrode zwangsläufig auch die aktive Schicht an denselben Stellen (nämlich an den Trennstellen) ebenfalls strukturiert. Beim Aufdrucken der oberen Elektrode besteht dann die Gefahr, dass leitendes Material durch die aktive Schicht hindurch bis zur unteren Elektrode vordringt und einen Kurzschluss erzeugt. Das zusätzlich aufgedruckte Sperrmaterial verhindert dies. Entsprechend ist das Sperrmaterial zweckmäßigerweise hinreichend isolierend und hierfür wie oben bereits beschrieben ein Dielektrikum oder Isolator.

Geeigneterweise wird das Sperrmaterial mit Strahlung ausgehärtet, ist also ein aushärtbares (Englisch: "curable") Material. Die Strahlung ist insbesondere UV-Strahlung, alternativ andere Strahlung z.B. IR-Strahlung oder thermische Strahlung oder eine Kombination hiervon, z.B. in einem 2K-System. "Thermische Strahlung" bedeutet insbesondere Heißluft, vorzugsweise mit einer Temperatur im Bereich von 80°C bis 120°C. Alternativ ist auch eine einfache Lufttrocknung möglich, bei hohen Fertigungsgeschwindigkeiten wie z.B. beim Inkjet-Druckverfahren, wird das Sperrmaterial jedoch vorzugsweise explizit mittels einer entsprechenden (ersten) Aushärteeinheit ausgehärtet. Die Aushärteeinheit ist entsprechend z.B. ein UV-, IR-, Mikrowellen- oder Heißlufttrockner (z.B. Konvektionstrockner) oder eine Kombination hiervon. Die Trocknungszeit, während welcher das Sperrmaterial ausgehärtet wird, liegt je nach Ausgestaltung der Aushärteeinheit insbesondere im Bereich von 0,2 s (z.B. mittels UV-Blitzlicht) bis 10 min (z.B. mittels Heißluft). Die Aushärteeinheit ist z.B. in die Druckeinheit für die Sperrschicht integriert oder separat davon ausgebildet und dann vorzugsweise direkt im Anschluss and die Druckeinheit angeordnet. Grundsätzlich kann die Aushärtung erfolgen, indem das Halbleiterelement während der Herstellung vollflächig mit der Strahlung bestrahlt wird. Dies hat unter Umständen eine Degradation der aktiven Schicht durch Ozon zur Folge, welches durch die Strahlung gebildet wird. Daher wird das Sperrmaterial geeigneterweise entweder unter einer Schutzatmosphäre ausgehärtet oder indem die Strahlung lediglich an den Trennstellen, d.h. ortsselektiv, angewendet wird. Die Schutzatmosphäre zeichnet sich insbesondere dadurch aus, dass diese sauerstofffrei ist, z.B. eine Edelgas-Atmosphäre ist. Bei der ortsselektiven Anwendung wird das Halbleiterelement dagegen lediglich an den Trennstellen bestrahlt, z.B. indem zur Bestrahlung ein Laser verwendet wird. Beide Varianten sind grundsätzlich auch miteinander kombinierbar.

Das Sperrmaterial wird zweckmäßigerweise ausgehärtet, noch bevor die obere Elektrode aufgedruckt wird. Die Aushärteeinheit ist entsprechend entlang einer Förderrichtung der Anlage zwischen den beiden Druckeinheiten oder Druckköpfen (bei nur einer Druckeinheit) zum Aufdrucken der Sperrschicht einerseits und der oberen Elektrode andererseits angeordnet.

Das Sperrmaterial ist entweder transparent oder opak, d.h. insbesondere transparent wenigstens für sichtbares Licht (400 nm bis 800 nm). Dadurch wird die optische Anmutung des Halbleiterbauteils verbessert. Unter "transparent" wird insbesondere eine Transparenz von wenigstens 70% verstanden, d.h. eine Absorption von höchstens 30%. Dabei ist das Sperrmaterial hinsichtlich der oben beschriebenen Aushärtung geeigneterweise hinreichend absorptiv für die dabei verwendete Strahlung. Zweckmäßigerweise weist das Sperrmaterial eine Farbe auf, welche an eine Farbe der aktiven Schicht angeglichen ist, , d.h. das Sperrmaterial und die aktive Schicht sind oder werden möglichst gleich gefärbt. Dadurch sind die Trennstellen, an welchen das Sperrmaterial aufgedruckt ist, im fertigen Halbleiterelement nicht mehr zu erkennen. Dies führt zu einer verbesserten Ästhetik oder optischen Anmutung. Das Sperrmaterial wird oder ist beispielsweise eingefärbt, indem verschieden gefärbte Tinten als Sperrmaterial zur Auswahl stehen und für den gegebenen Auftrag dann eine davon möglichst passend zur Farbe der aktiven Schicht ausgewählt wird, oder indem der Tinte für das Sperrmaterial ein entsprechender Farbstoff beigemischt wird.

Das Sperrmaterial wird vorzugsweise mit einer Schichtdicke im Bereich von 50 nm bis 500 nm, insbesondere weniger als 500 nm, aufgedruckt. Dies ist besonders mittels des beschriebenen Digitaldruckverfahrens problemlos möglich. Durch die genannte geringe Schichtdicke wird besonders wenig Material benötigt und der Schichtaufbau des Halbleiterelements bleibt auch besonders plan. Grundsätzlich vorteilhaft sind auch Schichtdicken bis höchstens 1 µm oder sogar bis höchstens 3 µm. Um eine ausreichende Sperrwirkung (d.h. Verhinderung eines Kurzschlusses) zu erzielen, beträgt die Schichtdicke außerdem vorzugsweise wenigstens 50 nm, besonders bevorzugt wenigstens 100 nm.

Die Tinte mit dem Sperrmaterial ist entweder lösungsmittelfrei und enthält dann insbesondere ausschließlich das Sperrmaterial oder enthält zusätzlich zu diesem noch ein Lösungsmittel (z.B. ein wasserbasiertes Lösungsmittel). Alternativ oder zusätzlich enthält die Tinte ein Vernetzungsmittel für das Sperrmittel und/oder zusätzliche Farbpigmente, um eine bestimmte Farbe zu erhalten.

Zum Aufdrucken der oberen Elektrode wird eine Tinte verwendet, welche ein elektrisch leitendes Material enthält, aus welchem dann die obere Elektrode ausgebildet wird. Das leitende Material ist vorzugsweise Silber, ebenfalls geeignet sind Kupfer, Gold, andere Metalle, Kohlenstoff in einer leitfähigen Konfiguration (z.B. Graphit) oder Kombinationen hiervon, speziell Kombinationen von Silber und Kupfer oder Silber und Kohlenstoff in einer leitfähigen Konfiguration. Zusätzlich enthält die Tinte zweckmäßigerweise ein Lösungsmittel, bevorzugt ein wasserbasiertes Lösungsmittel oder ein unpolares Lösungsmittelsystem für metallische Tinten, z.B. Propylenglycolmonomethyletheracetat (PGMEA).

Bevorzugterweise wird zum Aufdrucken der oberen Elektrode eine nicht-partikelbasierte, leitfähige Tinte verwendet oder eine Tinte, mit einer mittleren Partikelgröße im Bereich von 1 nm bis 5 µm. Geeigneterweise beträgt die Partikelgröße wenigstens 80 nm. Vorzugsweise ist die Partikelgröße der Tinte wenigstens um einen Faktor 2 geringer als die Schichtdicke der aktiven Schicht. Mittels einer solchen Tinte lassen sich besonders feine Strukturen erzeugen, speziell in Kombination mit einem Digitaldruckverfahren. Die Partikelgröße ist dabei die Partikelgröße des leitenden Materials, aus welchem die obere Elektrode letztendlich hergestellt wird, z.B. das zuvor bereits genannte Silber.

Auch die Tinte zur Herstellung der oberen Elektrode ist vorzugsweise aushärtbar. Eine Aushärtung erfolgt insbesondere nach dem Aufdrucken der oberen Elektrode, um diese final fertigzustellen, und mittels einer entsprechenden (zweiten) Aushärteeinheit. Die Ausführungen zum Aushärten des Sperrmaterials und zur ersten Aushärteeinheit gelten grundsätzlich analog auch für das Aushärten der oberen Elektrode und die zweite Aushärteeinheit. Im Gegensatz zum Sperrmaterial ist das Aushärten der oberen Elektrode jedoch insbesondere ein Sintern, bei welchem die aufgedruckte Elektrode über einen bestimmten Zeitraum bei einer bestimmten Temperatur gehalten wird. Geeigneterweise beträgt der Zeitraum maximal 10 min und die Temperatur maximal 120 °C und insbesondere wenigstens 40 °C, um einen elektrischen Widerstand von höchstens 0,5 Ω/cm² zu erhalten. Analog zu den Druckeinheiten ist es grundsätzlich auch möglich, dass zum Aushärten sowohl der Sperrschicht als auch der oberen Elektrode dieselbe Aushärteeinheit verwendet wird, welche dann in Förderrichtung stromab der Druckeinheit zum Aufdrucken der oberen Elektrode angeordnet ist. Da sich aber das Sperrmaterial und das Material der oberen Elektrode typischerweise unterscheiden, sind auch unterschiedliche Aushärteverfahren vorteilhaft, um auf die jeweiligen Besonderheiten der Materialien optimal zu reagieren. So ist z.B. für die Sperrschicht ein UV-Trockner besonders vorteilhaft, für die obere Elektrode hingegen ein Heißluft- oder Mikrowellentrockner. Auch ergeben sich typischerweise unterschiedliche Trocknungszeiten für das Sperrmaterial und die obere Elektrode, letztere benötigt regelmäßig länger zum Aushärten.

Die obere Elektrode wird vorteilhafterweise mit einer Schichtdicke im Bereich von 100 nm bis 1000 nm hergestellt und ist damit besonders dünn. Dabei wird die obere Elektrode insbesondere mit einer solchen Schichtdicke aufgedruckt, dass eine Überdeckung des Sperrmaterials an den Trennstellen gewährleistet ist, sodass die obere Elektrode nicht ungewollt an den Trennstellen unterbrochen ist.

Zweckmäßigerweise wird an einer oder mehreren Kontaktstellen jeweils eine Durchkontaktierung aufgedruckt, welche durch die aktive Schicht hindurchreicht und welche die obere mit der unteren Elektrode elektrisch leitend verbindet. Die Kontaktstellen sind demnach Positionen für Durchkontaktierungen des Halbleiterelements, ähnlich wie die Trennstellen Positionen für das Sperrmaterial sind. Für jede Durchkontaktierung wird insbesondere genau eine Kontaktstelle ausgebildet. Die Durchkontaktierungen dienen zur Herstellung einer Serien- oder Parallelschaltung mehrerer Zellen. Hierzu verbindet eine jeweilige Durchkontaktierung eine Teilelektrode der unteren Elektrode mit einer benachbarten Teilelektrode der oberen Elektrode.

Analog zur oberen Elektrode wird auch für die Durchkontaktierungen eine Tinte verwendet, welche ein leitendes Material enthält. Die obigen Ausführungen gelten entsprechend. Besonders zweckmäßig ist eine Ausgestaltung, bei welcher für die obere Elektrode und die Durchkontaktierungen die gleiche Tinte verwendet wird.

In einer ersten, geeigneten Ausgestaltung wird, bevor die Durchkontaktierungen aufgedruckt werden, die aktive Schicht an den Kontaktstellen strukturiert, sodass an einer jeweiligen Kontaktstelle die untere Elektrode freigelegt wird. Mit anderen Worten: in der aktiven Schicht wird an jeder Kontaktstelle eine Unterbrechung erzeugt, die untere Elektrode bleibt dabei jedoch soweit wie möglich erhalten. Diese Strukturierung lediglich der aktiven Schicht wird auch als P2-Strukturierung bezeichnet, erfolgt in einem P2-Strukturierungsschritt und dient der Durchbrechung der aktiven Schicht zwecks Kontaktierung der beiden Elektroden. Die aktive Schicht wird an den Kontaktstellen vorzugsweise mit einem Laser strukturiert. Diesbezüglich gelten die obigen Ausführungen zur P1'-Strukturierung mittels Laser analog. Für die P2-Strukturierung werden allerdings zumindest hinsichtlich der unterschiedlichen Zielsetzung bei der Bearbeitung andere Parameter für den Laser gewählt, dies betrifft insbesondere die Leistung oder Pulsenergie des Lasers, nicht jedoch unbedingt dessen Arbeitsbreite. Die P2-Strukturierung erfolgt bevorzugterweise zusammen mit der P1*-Strukturierung, sodass der P1*-Strukturierungsschritt und der P2-Strukturierungsschritt in einem gemeinsamen Strukturierungsschritt zusammengefasst sind, nämlich dem zweiten Schritt des Verfahrens, und mittels einer einzelnen Strukturierungseinheit der Anlage durchgeführt werden. Die Strukturierung der aktiven Schicht an den Kontaktstellen erfolgt dann vorteilhafterweise gemeinsam mit der Strukturierung der unteren Elektrode (an den Trennstellen) in einem einzelnen Strukturierungsschritt. Dadurch ist die Anlage besonders kompakt und einfach, insbesondere wird lediglich ein einzelner Laser benötigt, um alle erforderlichen Strukturierungen vorzunehmen. Alternativ erfolgen die P1*-Strukturierung und die P2-Strukturierung aber separat voneinander. Insbesondere kann die P2-Strukturierung entweder vor oder auch nach dem Aufdrucken des Sperrmaterials erfolgen, da die P2-Strukturierung insbesondere nicht mit den Trennstellen überlappt.

Durch die Strukturierung der aktiven Schicht wird an einer jeweiligen Kontaktstelle vorteilhafterweise ein Kanal ausgebildet, welcher zweckmäßigerweise derart dimensioniert ist, dass die Tinte, aus welcher die Durchkontaktierungen hergestellt werden, mittels Kapillareffekt in den Kanal einzieht. Der Kanal ist eine Unterbrechung der aktiven Schicht. In einer geeigneten Ausgestaltung weist der Kanal eine Breite von maximal 200 µm, bevorzugt maximal 10 µm auf.

Die beschriebene P2-Strukturierung ist jedoch nicht zwingend erforderlich und entsprechend wird in einer zweiten geeigneten Ausgestaltung auf eine P2-Strukturierung verzichtet. Stattdessen werden die Durchkontaktierungen an den Kontaktstellen zweckmäßigerweise in die aktive Schicht hinein gedruckt, nämlich mittels einer Tinte, welche die aktive Schicht auflöst oder verdrängt. Im Gegensatz zur P2-Strukturierung wird demnach die aktive Schicht an den Kontaktstellen nicht vor der Ausbildung der Durchkontaktierungen und separat hierzu entfernt, sondern die Durchkontaktierungen werden derart in die aktive Schicht hinein gedruckt, dass diese exakt an den Kontaktstellen durch die Tinte, welche für die Durchkontaktierungen verwendet wird, verdrängt oder aufgelöst wird. Insbesondere zum Auflösen der aktiven Schicht weist die Tinte ein entsprechend geeignetes Lösungsmittel auf.

Die Kontaktstellen und die Trennstellen sind bevorzugterweise räumlich voneinander getrennt, d.h. die Unterbrechungen an den Trennstellen werden räumlich getrennt von den Durchkontaktierungen und gegebenenfalls den Unterbrechungen an den Kontaktstellen ausgebildet. Mit anderen Worten: die Kontaktstellen und die Trennstellen grenzen nicht unmittelbar aneinander an, sondern sind voneinander beabstandet, insbesondere derart, dass zwischen je einer Kontaktstelle und einer Trennstelle eine Insel der aktiven Schicht verbleibt. Dies ergibt sich insbesondere aus den geringen Abmessungen (speziell Breiten) der Unterbrechungen, welche an den Kontaktstellen und den Trennstellen erzeugt werden, besonders dann, wenn hierzu ein Laser verwendet wird. Ein Abstand zwischen Kontaktstellen und Trennstellen ist aber auch bezüglich des Sperrmaterials vorteilhaft, damit dieses nicht mit der P2-Strukturierung überlappt und durch diese beschädigt wird. Eine Aneinanderreihung oder Überlappung von Kontaktstellen und Trennstellen wird daher vorzugsweise vermieden. Der Abstand entspricht auch einer Breite der Insel.

In einer geeigneten Ausgestaltung ist die aktive Schicht ein Stapel mehrerer, insbesondere zweier Einzelschichten aus unterschiedlichen aktiven Materialien. Diese Materialien unterscheiden sich, sind aber beides organische Haltleitermaterialien. Vorzugsweise wird dann die aktive Schicht zusätzlich strukturiert, indem diese an Teilunterbrechungsstellen lediglich teilweise durchbrochen wird, d.h. insbesondere dass zumindest eine der Einzelschichten durchbrochen wird, eine andere der Einzelschichten jedoch nicht, d.h. intakt bleibt. Eine solche Strukturierung, bei welcher die aktive Schicht an Teilunterbrechungsstellen lediglich teilweise durchbrochen wird, wird auch als P3-Strukturierung bezeichnet, welche entsprechend in einem P3-Strukturierungsschritt erfolgt. Dieser wird mittels einer (dritten) Strukturierungseinheit durchgeführt, welche entweder separat zu oder identisch mit der ersten und/oder zweiten Strukturierungseinheit ist. Die Ausführungen zur ersten und zweiten Strukturierungseinheit gelten analog auch für die dritte Strukturierungseinheit. Insbesondere wird auch für die P3-Strukturierung vorzugsweise ein Laser verwendet.

Der Laser ist vorzugsweise ein ps- oder ns-Pulslaser. Ein solcher Laser ist für alle Strukturierungen geeignet.

Bevorzugt ist, dass jegliche Strukturierung (P1 *-, P2-, P3-Strukturierung, sofern jeweils vorhangen) durchgeführt und fertiggestellt wird, bevor das Sperrmaterial und die obere Elektrode aufgedruckt werden, sodass sämtliche Strukturierungseinheiten dann in Förderrichtung stromauf jeglicher Druckeinheiten angeordnet sind. Sofern die Anlage für alle Strukturierungen nur eine einzelne Strukturierungseinheit und für jegliches Aufdrucken nur eine einzelne Druckeinheit aufweist, ist die Anlage entsprechend kompakt. Dies wird vorliegend vor allem durch die spezielle Reihenfolge der Schritte des Verfahrens und das Konzept der "late stage customization" ermöglicht, wodurch die Strukturierungsschritte und/oder die Druckschritte jeweils zusammenfassbar sind. Beispielsweise sind sämtliche Strukturierungsschritte zu einem einzelnen Strukturierungsschritt zusammengefasst und zumindest die Druckschritte für die Durchkontaktierungen und die obere Elektrode sowie für gegebenenfalls weitere Leiterstrukturen wie z.B. Sammelleiter sind zu einem einzelnen Druckschritt zusammengefasst.

In einer vorteilhaften Ausgestaltung werden die Durchkontaktierungen oder allgemein wenigstens eine weitere Leiterstruktur gemeinsam mit der oberen Elektrode aufgedruckt und aus der gleichen Tinte hergestellt und gemeinsam in einem einzelnen Druckschritt. Die Durchkontaktierungen und alternativ oder zusätzlich auch andere Leiterstrukturen (z.B. Sammelleiter) und die obere Elektrode werden demnach mit derselben Druckeinheit hergestellt, insbesondere sogar mit demselben Druckkopf dieser Druckeinheit. Es werden also unterschiedliche Leitstrukturen mit demselben Druckkopf gemeinsam in einem einzelnen Druckschritt aufgedruckt.

Dadurch wird die Anlage insgesamt besonders kompakt, das Verfahren wird weiter beschleunigt und ist insgesamt auch kostengünstiger. Die Durchkontaktierungen und die obere Elektrode werden dann im gleichen Verfahrensschritt (dem genannten Druckschritt) aufgedruckt, nämlich dem weiter oben genannten vierten Schritt. Dabei werden die obere Elektrode und die Durchkontaktierungen insbesondere nicht separat voneinander in unterschiedlichen Teilschritten aufgedruckt, sondern tatsächlich als eine einzelne, monolithische Struktur. Entsprechend werden die Durchkontaktierungen und die obere Elektrode gegebenenfalls auch gemeinsam ausgehärtet. Vorzugsweise wird zum Aufdrucken der oberen Elektrode und der Durchkontaktierungen derselbe Farbkanal verwendet.

Zur Ausbildung der Durchkontaktierungen wird die Tinte an den Kontaktstellen zweckmäßigerweise mit größerer Schichtdicke aufgedruckt, als außerhalb der Kontaktstellen. Dadurch wird sichergestellt, dass an den Kontaktstellen hinreichend viel Material aufgetragen wird, um eine funktionierende Durchkontaktierung auszubilden. Die Schichtdicke ist besonders bei einem Digitaldruckverfahren durch entsprechende Anpassung der lokal aufgetragenen Menge an Tinte z.B. mittels Graustufendruck, besonders einfach einstellbar.

Ein Vorteil eines Digitaldruckverfahrens gegenüber z.B. einem Siebdruckverfahren ist, dass ein Graustufendruck besonders einfach und schnell durchführbar ist, mit welchem sich in einem einzelnen Druckschritt unterschiedliche Schichtdicken realisieren lassen. Entsprechend wird zum Aufdrucken der Tinte mit unterschiedlicher Schichtdicke geeigneterweise ein Graustufendruck verwendet. Damit lassen sich die obere Elektrode und die Durchkontaktierungen sowie auch andere Leiterstrukturen, z.B. Sammelleiter (Busbars), welche gegebenenfalls unterschiedliche elektrische Leitfähigkeiten aufweisen sollen, mittels eines einzelnen Farbkanals der Druckeinheit der Anlage herstellen. Mit dem Graustufendruck wird dann die Schichtdicke zu jedem Zeitpunkt so eingestellt, dass sich für die an dieser Stelle aufgedruckte Leitstruktur eine vorgegebene Leitfähigkeit ergibt. Dabei wird ausgenutzt, dass beim Aufdrucken der Tinte die aufgedruckte Menge (Menge pro Punkt oder Menge pro Fläche) der Tinte über einen Grauwert einstellbar ist, welcher auf einfache Weise in einer Bilddatei speicherbar ist. Die Menge an aufgedruckter Tinte bestimmt dann auch die Schichtdicke und entsprechend die Leitfähigkeit. In einer bevorzugten Ausgestaltung wird dann die obere Elektrode gemeinsam mit wenigstens einer weiteren Leiterstruktur (Durchkontaktierung, Sammelleiter usw.) aufgedruckt, für welche eine andere Leitfähigkeit vorgegeben ist als für die obere Elektrode. Es sollen also Leitstrukturen mit unterschiedlicher Leitfähigkeit gemeinsam gedruckt werden. Die obere Elektrode und die wenigstens eine weitere Leitstruktur werden nun dadurch mit unterschiedlicher Leitfähigkeit hergestellt, dass zum entsprechenden Aufdrucken der Tinte mit unterschiedlicher Schichtdicke ein Graustufendruck verwendet wird.

Mit den beschriebenen Strukturierungsschritten und Druckschritten lassen sich besonders kleine Liniendimensionen besonders genau erzielen, speziell dann, wenn ein Laser zur Strukturierung und ein Digitaldruckverfahren zum Aufdrucken verwendet wird. Unter "Liniendimensionen" werden Breite und Höhe der jeweils erzeugten Strukturen (Leiterstrukturen, z.B. Durchkontaktierungen, und Unterbrechungen, z.B. Trennstellen) verstanden. Die Breite liegt insbesondere im Bereich von 50 nm bis 300 µm, die Höhe liegt insbesondere im Bereich von 100 nm bis 15 µm, sodass also speziell Dünnschicht-Photovoltaikelemente gut herstellbar sind.

Ein erfindungsgemäßes organisches Halbleiterelement ist vorzugsweise gemäß dem Verfahren wie oben beschriebenen hergestellt. Entsprechend weist das Halbleiterelement eine untere Elektrode, eine aktive Schicht und eine obere Elektrode auf. Die untere Elektrode und die aktive Schicht sind strukturiert und dadurch sind eine oder mehrere Trennstellen ausgebildet, welche die untere Elektrode in mehrere untere Teilelektroden unterteilen. An den Trennstellen ist ein Sperrmaterial aufgedruckt, um eine Kontaktierung der unteren Elektrode mit der oberen Elektrode an den Trennstellen zu verhindern. Die obere Elektrode ist auf die aktive Schicht aufgedruckt.

Eine erfindungsgemäße Anlage ist ausgebildet zur Durchführung eines Verfahrens wie vorstehend beschrieben. Die Anlage weist eine oder mehrere Strukturierungseinheiten und eine oder mehrere Druckeinheiten wie oben beschrieben auf. Insbesondere weist die Anlage auch einen Abroller auf, von welchem aus das Halbzeug in Form einer Rolle in Förderrichtung abgerollt wird und den Strukturierungseinheiten und Druckeinheiten nacheinander zugeführt wird. Die Rolle weist beispielsweise eine Breite im Bereich von 10 cm bis 120 cm auf. Die zur Rolle aufgerollte Materialbahn weist beispielsweise (in abgerollten Zustand) eine Länge von 10 m bis 1000 m auf. Wie bereits beschrieben, sind vorzugsweise sämtliche Strukturierungseinheiten stromauf sämtlicher Druckeinheiten angeordnet, sodass die Strukturierung und das Aufdrucken entsprechend getrennt sind. Optional weist die Anlage je nach Bedarf auch eine oder mehrere Aushärteeinheiten wie oben beschrieben auf. Geeigneterweise ist die Anlage als einzelne Maschine konzipiert, bei welcher sowohl die Strukturierungsschritte als auch die Druckschritte inline und ohne Zwischenlagerung oder Unterbrechung erfolgen. Optional erfolgt auch eine Herstellung des Halbzeugs oder eine Beschichtung innerhalb der Anlage. Grundsätzlich geeignet ist aber auch eine Alternative, bei welcher die Anlage zwei Maschinen aufweist, welche grundsätzlich unabhängig voneinander betrieben werden und von welchen die eine Maschine lediglich die Strukturierungsschritte durchführt (Strukturierungsmaschine) und die andere Maschine lediglich die Druckschritte (Druckmaschine).

Nachfolgend werden Ausführungsbeispiele der Erfindung anhand einer Zeichnung näher erläutert. Darin zeigen jeweils schematisch:
- Fig. 1a: ein Verfahren zur Herstellung eines organischen Halbleiterelements,
- Fig. 1b: ein Ausführungsbeispiel des Verfahrens aus Fig. 1a in einer Detailansicht,
- Fig. 2: das Halbleiterelement nach einem ersten Schritt des Verfahrens aus Fig. 1a,
- Fig. 3: das Halbleiterelement nach einem zweiten Schritt des Verfahrens aus Fig. 1a,
- Fig. 4: das Halbleiterelement nach einem dritten Schritt des Verfahrens aus Fig. 1a,
- Fig. 5: das Halbleiterelement nach einem vierten Schritt des Verfahrens aus Fig. 1a,
- Fig. 6: eine Anlage zur Durchführung des Verfahrens aus Fig. 1a oder 1b.

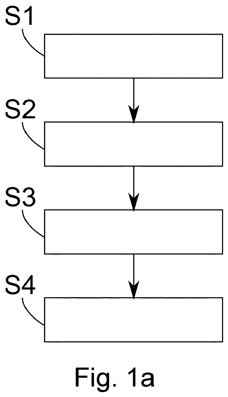

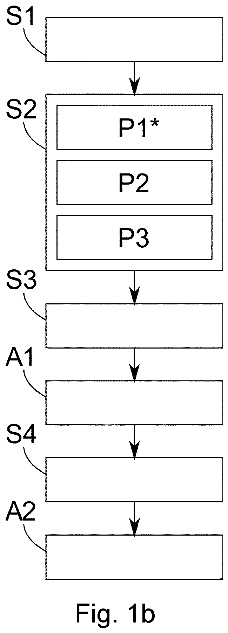

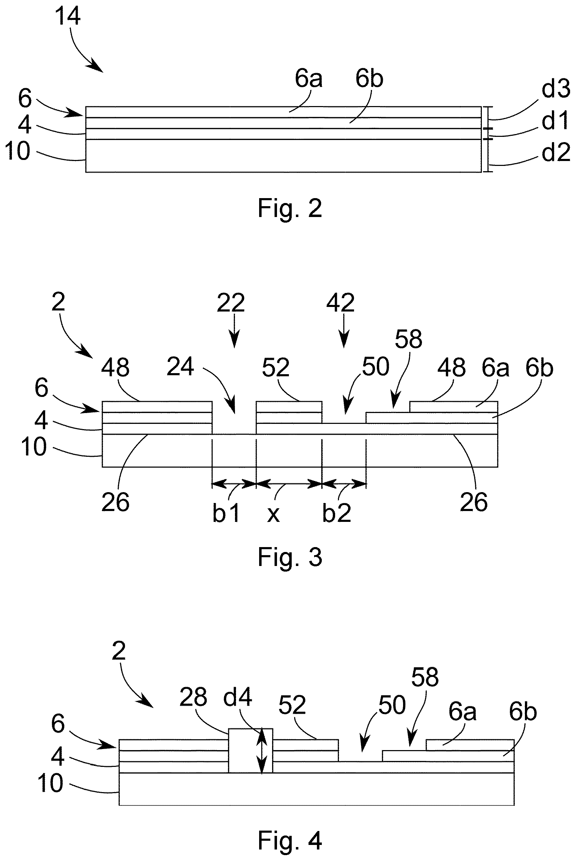

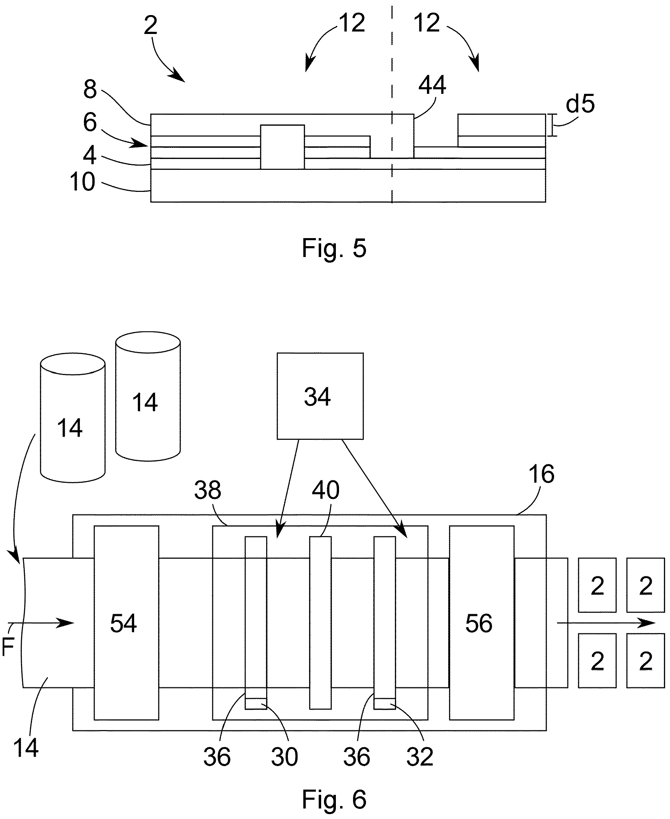

In Fig. 1a ist ein allgemeines Ausführungsbeispiel des erfindungsgemäßen Verfahrens mit vier Schritten S1, S2, S3, S4 gezeigt. In Fig. 1b ist ein Ausführungsbeispiel für das Verfahren etwas detaillierter gezeigt. Das Verfahren dient zur Herstellung eines organischen Halbleiterelements 2, hier eines organischen Dünnschicht-Photovoltaikelements. In den Fig. 2 bis 5 ist das Halbleiterelement 2 am Ende eines jeweiligen der Schritte S1, S2, S3, S4 gezeigt, speziell zeigt Fig. 5 dann auch ausschnittsweise und in einer Querschnittansicht das fertige Halbleiterelement 2. Dieses weist eine untere Elektrode 4, eine aktive Schicht 6 und eine obere Elektrode 8 auf. Diese bilden zusammen mit einem Substrat 10 eine Schichtstruktur. Im Rahmen des Verfahrens werden die untere Elektrode 4, die aktive Schicht 6 und die obere Elektrode 8 geeignet strukturiert ausgebildet und die Elektroden 4, 8 miteinander verbunden, um mehrere Zellen 12 auszubilden, welche elektrisch miteinander verschaltet sind. Die genaue Form, Größe und Verschaltung der Zellen 12 ist durch eine Designentscheidung vorgegeben.

Im ersten Schritt S1 (siehe Fig. 2) des Verfahrens wird ein Halbzeug 14 bereitgestellt, welches die untere Elektrode 4 aufweist sowie die aktive Schicht 6, welche auf die untere Elektrode 4 aufgetragen ist. Dabei sind die die untere Elektrode 4 und die aktive Schicht 6 jeweils unstrukturiert und vollflächig ausgebildet. Bei dem Halbzeug 14 ist noch keine Designentscheidung getroffen worden oder zumindest noch nicht notwendig und in dessen Herstellung jedenfalls nicht eingeflossen.

Allgemein wird das Verfahren auf einer entsprechenden Anlage 16 ausgeführt, für welche ein Ausführungsbeispiel in Fig. 6 gezeigt ist. Das Halbzeug 14 wird in die Anlage 16 eingegeben und diese gibt am Ende das fertige Halbleiterelement 2 aus (typischerweise mehrere Halbleiterelemente). Die Anlage 16 weist allgemein eine Förderrichtung F auf, in welcher das Halbzeug 14 durch die Anlage 16 gefördert wird. Das Halbzeug 14 wird in Fig. 6 in aufgerollter Form, d.h. als aufgerollte Materialbahn und als Rolle, bereitgestellt, welche dann im Rahmen des Verfahrens abgerollt und wie nachfolgend beschrieben weiterverarbeitet wird, sodass das Verfahren dann ein Rollenverarbeitungsverfahren ist. Am Ende des Verfahrens wird die Materialbahn beispielsweise wieder aufgerollt oder, wie in Fig. 6 gezeigt, zusätzlich konfektioniert, z.B. zu mehreren einzelnen Halbleiterelementen 2 vereinzelt. In einer nicht gezeigten Alternative werden auch die untere Elektrode 4 oder die aktive Schicht 6 oder beide erst in der Anlage 16 aufgedruckt, dann jedoch vorzugsweise jeweils zunächst vollflächig.

Die untere Elektrode 4 weist z.B. eine Schichtdicke d1 im Bereich von 10 nm bis 500 nm auf. Das Substrat 6 besteht z.B. aus einem transparenten Kunststoff, dient als robuste Unterlage bei der Fertigung des Halbleiterelements 2 und weist eine Schichtdicke d2 z.B. im Bereich von 10 µm bis 500 µm auf. Die untere Elektrode 4 ist auf das Substrat 6 z.B. aufgesputtert, beschichtet oder gedruckt und aus einem transparenten, leitenden Material hergestellt. Die aktive Schicht 6 ist auf die untere Elektrode 4 aufgetragen und wird vorliegend aus zwei Einzelschichten 6a, 6b gefertigt, welche jeweils aus einem aktiven Material bestehen.

Im zweiten Schritt S2 des Verfahrens (siehe Fig. 3) wird die untere Elektrode 4 durch die aktive Schicht 6 hindurch strukturiert und dabei wird an einer oder mehreren Trennstellen 22 jeweils eine Unterbrechung 24 (erste Unterbrechung) ausgebildet, welche die untere Elektrode 4 in mehrere untere Teilelektroden 26 unterteilen, d.h. in der unteren Elektrode 4 und in der aktiven Schicht 6 wird an einer jeweiligen Trennstelle 22 eine Unterbrechung erzeugt. Im zweiten Schritt S2 erfolgt demnach eine Strukturierung der unteren Elektrode 4, welche auch als P1*-Strukturierung P1* bezeichnet wird. Der zweite Schritt S2 enthält demnach einen P1*-Strukturierungsschritt P1*. Diese P1*-Strukturierung erfolgt mittels einer Strukturierungseinheit 54 der Anlage 16. Die genaue Lage der Trennstellen 22 ist Teil einer Designentscheidung für das Halbleiterelement 2.

Die untere Elektrode 4 (und damit auch die aktive Schicht 6) wird vorliegend derart strukturiert, dass an einer jeweiligen Trennstelle 22 als Unterbrechung 24 ein Graben ausgebildet ist, welcher beidseitig durch nunmehr voneinander getrennte Teilbereiche der unteren Elektrode 4 und der aktiven Schicht 6 berandet ist. Die Teilbereiche der unteren Elektrode 4 entsprechen den bereits genannten Teilelektroden 26. Eine jeweilige Unterbrechung 24 weist eine Breite b1 von z.B. maximal 20 µm auf. Vorliegend wird die untere Elektrode 4 mit einem Laser als Strukturierungseinheit 54 strukturiert, mit welchem die genannte, geringe Breite b1 realisiert ist.

Im dritten Schritt S3 (siehe Fig. 4) wird mit einer Druckeinheit 38 der Anlage 16 an den Trennstellen 22 ein Sperrmaterial 28 aufgedruckt, um eine Kontaktierung der unteren Elektrode 4 mit der oberen Elektrode 8 an den Trennstellen 22 zu verhindern. Der zweite und der dritte Schritt S2, S3 sind in beliebiger Reihenfolge ausführbar. Im vierten Schritt S4 (siehe Fig. 5) wird dann mit derselben Druckeinheit 38 die obere Elektrode 8 auf die aktive Schicht 6 aufgedruckt. Das Sperrmaterial 28 ist z.B. ein Dielektrikum oder ein Isolator und allgemein elektrisch schwach leitend oder nicht leitend. Der dritte Schritt S3 wird auch als erster Druckschritt bezeichnet und der vierte Schritt S4 wird als zweiter Druckschritt bezeichnet. Vorliegend wird nur ein einzelne Druckeinheit 38 zum Aufdrucken sowohl im dritten Schritt S3 als auch im vierten Schritt S4 verwendet, das Aufdrucken des Sperrmaterials 28 und der oberen Elektrode 8 erfolgt dann mittels je einem entsprechenden Druckkopf 36 der Druckeinheit 38. Grundsätzlich können aber alternativ auch zwei voneinander getrennte Druckeinheiten verwendet werden (nicht gezeigt).

Bei der hier gezeigten Ausführungsform werden sowohl das Sperrmaterial 28 als auch die obere Elektrode 8 jeweils mittels eines Digitaldruckverfahrens, speziell mittels eines Inkjet-Druckverfahrens aufgedruckt. Das Sperrmaterial 28 und ein Material für die obere Elektrode 8 sind ein Teil einer jeweiligen Tinte 30, 32, welche im Rahmen des Verfahrens aufgedruckt wird. Bei dem Digitaldruckverfahren wird eine Tinte auf Basis digitaler Bilddaten 34 aus einem jeweiligen Druckkopf 36 punktgenau und mit hoher Auflösung auf das Halbzeug 14 auftragen.

Das Digitaldruckverfahren zeichnet sich dadurch aus, dass dieses kontaktfrei ist, ein Kontakt mit dem Halbzeug 14 besteht dabei nicht. Dadurch wird speziell beim Aufdrucken der oberen Elektrode 8 verhindert, dass leitendes Material an ungewollter Stelle in die aktive Schicht 6 hineingepresst wird. Mit dem Digitaldruckverfahren kann daher nun die Lochleitungsschicht 6a der aktiven Schicht 6 dünner ausgebildet werden. Die gesamte aktive Schicht 6 weist eine Schichtdicke d3 auf.

Das Digitaldruckverfahren ist zudem besonders einfach konfigurierbar, speziell lässt sich ein Wechsel des Auftrags ohne Werkzeugwechsel und rein softwarebasiert umsetzen, denn es genügt, lediglich die Ansteuerung der Druckköpfe 36 an einen neuen Auftrag anzupassen. Eine Umrüstung der Anlage 16 ist dagegen nicht erforderlich. Vielmehr wird zum Drucken des Sperrmaterials 28 und der oberen Elektrode 8 die Druckeinheit 38 mittels entsprechender Auftragsdaten geeignet angesteuert, um die jeweilige Tinte 30, 32 je nach Auftrag individuell aufzudrucken. Die Auftragsdaten enthalten entsprechende Bilddaten 34, in welchen die Designentscheidung kodiert ist und auf Basis derer dann die Druckeinheit 38 angesteuert wird.

Bei dem Digitaldruckverfahren werden je nach Ausgestaltung der Druckeinheit 38 verschiedene Tinten 30, 32 vorgehalten, um die Gestaltungsfreiheit weiter zu erhöhen. In einer nicht explizit gezeigten Ausgestaltung werden für das Sperrmaterial 28 mehrere verschiedene Tinten 30 bereitgestellt, sodass bei der Herstellung je nach Bedarf zwischen diesen Tinten 30 gewechselt wird. Beispielsweise weisen die Tinten 30 verschiedene Farben auf, wodurch das Aussehen des Halbleitermoduls 2 entsprechend mehrfarbig oder auch gezielt einfarbig gestaltbar ist. Gleiches gilt alternativ oder zusätzlich analog auch für die obere Elektrode 8 und die hierzu verwendete Tinte 32. Im hier gezeigten Ausführungsbeispiel werden unterschiedliche Farbkanäle einer Druckeinheit 38 für unterschiedliche Teile des Hableitermoduls 2 verwendet, nämlich ein erster Farbkanal für das Sperrmaterial 28 und ein zweiter Farbkanal für die obere Elektrode 8. Zur Durchführung eines Auftrags werden einfache Bilddaten 34, z.B. eine Bilddatei, verwendet, bei welchen ein jeweiliger Farbkanal die entsprechenden Daten zum Aufdrucken des Sperrmaterials 28 und der oberen Elektrode 8 enthält.

Da das Sperrmaterial 28 möglichst wenig elektrisch leitend sein soll, die obere Elektrode 8 dagegen möglichst gut leitend, werden konsequenterweise beim Drucken des Sperrmaterials 28 und der oberen Elektrode 8 verschiedene Tinten 30, 32 mit der entsprechend jeweils erforderlichen Eigenschaft verwendet. Die im Verfahren genutzten Bilddaten 34 weisen entsprechend wenigstens zwei Farbkanäle auf. Außerdem wird die obere Elektrode 8 erst nach dem Sperrmaterial 28 aufgedruckt, da dieses gerade dazu dient, an den Trennstellen 22 ein Vordringen der Tinte 32 bis zur unteren Elektrode 4 und damit einen Kurzschluss der beiden Elektroden 4, 8 zu verhindern.

Das Sperrmaterial 28 wird vorliegend mittels einer ersten Aushärteeinheit 40 mit UV-Strahlung ausgehärtet, ist also ein aushärtbares Material. Die Aushärtung erfolgt beispielsweise im dritten Schritt S3 nach dem Aufdrucken des Sperrmaterials 28 oder im vierten Schritt S4 vor dem Aufdrucken der oberen Elektrode 8 oder - wie hier gezeigt - in einem separaten Schritt, nämlich einem ersten Aushärteschritt A1 zwischen dem dritten und dem vierten Schritt S3, S4. Vorliegend wird das Sperrmaterial 28 somit ausgehärtet, noch bevor die obere Elektrode 8 aufgedruckt wird. Die Aushärteeinheit 40 ist entsprechend entlang der Förderrichtung F zwischen den beiden Druckköpfen 36 zum Aufdrucken der Sperrschicht 28 einerseits und der oberen Elektrode 8 andererseits angeordnet und hier auch in die Druckeinheit 38 integriert. Das Sperrmaterial 28 wird entweder unter einer Schutzatmosphäre ausgehärtet oder indem die Strahlung 40 lediglich an den Trennstellen 22 angewendet wird, um eine Degradation der aktiven Schicht 6 durch Ozon zu vermeiden.

Weiterhin wird das hier verwendete Sperrmaterial 28 mit einer Schichtdicke d4 im Bereich von z.B. 100 nm bis weniger als 500 nm aufgedruckt. Durch die genannte geringe Schichtdicke wird besonders wenig Material benötigt und der Schichtaufbau des Halbleiterelements 2 bleibt besonders plan. Das Sperrmaterial 28 ist entweder transparent oder opak. Optional weist das Sperrmaterial 28 eine Farbe auf, welche an eine Farbe der aktiven Schicht 6 angeglichen ist oder wird, d.h. die Sperrmaterial 28 und die aktive Schicht 6 sind oder werden möglichst gleich gefärbt. Beispielsweise wird das Sperrmaterial 28 entsprechend derart eingefärbt, dass dessen Farbe an eine Farbe der aktiven Schicht 6 angeglichen ist. Dadurch sind die Trennstellen 22, an welchen das Sperrmaterial 28 aufgedruckt ist, im fertigen Halbleiterelement 2 nicht mehr zu erkennen. Dies führt zu einer verbesserten Ästhetik oder optischen Anmutung. Das Sperrmaterial 28 wird oder ist beispielsweise eingefärbt, indem verschieden gefärbte Tinten 30 als Sperrmaterial 28 zur Auswahl stehen und für den gegebenen Auftrag dann eine davon möglichst passend zur Farbe der aktiven Schicht 6 ausgewählt wird, oder indem der Tinte 30 für das Sperrmaterial 28 ein entsprechender Farbstoff beigemischt wird.

Zum Aufdrucken der oberen Elektrode 8 wird eine Tinte 32 verwendet, welche ein elektrisch leitendes Material enthält, aus welchem dann die obere Elektrode 8 ausgebildet wird. Das leitende Material ist z.B. Silber, ebenfalls geeignet sind Kupfer, Gold, andere Metalle, Kohlenstoff in einer leitfähigen Konfiguration (z.B. Graphit) oder Kombinationen hiervon, speziell Kombinationen von Silber und Kupfer oder Silber und Kohlenstoff in einer leitfähigen Konfiguration. Zusätzlich enthält die Tinte 32 optional ein Lösungsmittel. Die Tinte 32 für die obere Elektroden 8 ist vorliegend aushärtbar. Eine Aushärtung erfolgt z.B. nach dem Aufdrucken der oberen Elektrode 8 und noch im vierten Schritt S4 oder - wie hier gezeigt - in einem separaten Schritt danach, nämlich dem zweiten Aushärteschritt A2. Das Aushärten erfolgt mit einer zweiten Aushärteeinheit 56 und ist z.B. ein Sintern, bei welchem die aufgedruckte Elektrode 8 über einen Zeitraum von z.B. 5 min mit Heißluft bei einer bestimmten Temperatur von z.B. 120 °C gehalten wird, um z.B. einen elektrischen Widerstand von höchstens 0,5 Ω/cm² zu erhalten.

Die obere Elektrode 8 wird mit einer Schichtdicke d5 z.B. im Bereich von 100 nm bis 1000 nm hergestellt. Beispielsweise wird die obere Elektrode 8 mit einer solchen Schichtdicke d5 aufgedruckt, dass eine Überdeckung des Sperrmaterials 28 an den Trennstellen 22 gewährleistet ist, sodass die obere Elektrode 8 nicht ungewollt an den Trennstellen 22 unterbrochen ist.

Bei dem hier gezeigten Ausführungsbeispiel wird zusätzlich an einer oder mehreren Kontaktstellen 42 jeweils eine Durchkontaktierung 44 aufgedruckt, welche durch die aktive Schicht 6 hindurchreicht und welche die obere Elektrode 8 mit der unteren Elektrode 4 elektrisch leitend verbindet. Die Kontaktstellen 42 sind demnach Positionen für Durchkontaktierungen 44 des Halbleiterelements 2, ähnlich wie die Trennstellen 22 Positionen für das Sperrmaterial 28 sind. Für jede Durchkontaktierung 44 wird genau eine Kontaktstelle 42 ausgebildet. Die Durchkontaktierungen 44 dienen zur Herstellung einer Serienschaltung mehrerer Zellen 12. Hierzu verbindet eine jeweilige Durchkontaktierung 44 eine Teilelektrode 26 der unteren Elektrode 4 mit einer benachbarten oberen Teilelektrode 48 der oberen Elektrode 8. Analog zur oberen Elektrode 8 wird auch für die Durchkontaktierungen 44 eine Tinte 32 verwendet, welche ein leitendes Material enthält, vorliegend wird sogar für die obere Elektrode 8 und die Durchkontaktierungen 44 die gleiche Tinte 32 verwendet und die Durchkontaktierungen 44 werden auch mit demselben Druckkopf 36 aufgedruckt wie die obere Elektrode 8 und somit gemeinsam mit dieser im vierten Schritt S4.

In einer ersten Ausgestaltung wird, wie in Fig. 3 gezeigt, die aktive Schicht 6 an den Kontaktstellen 42 strukturiert, sodass an einer jeweiligen Kontaktstelle die untere Elektrode 4 freigelegt wird. Mit anderen Worten: in der aktiven Schicht 6 wird an jeder Kontaktstelle 42 eine Unterbrechung 50 (zweite Unterbrechung) erzeugt, die untere Elektrode 4 bleibt dabei jedoch soweit wie möglich erhalten. Dies erfolgt noch bevor die Durchkontaktierungen 44 aufgedruckt werden. Diese Strukturierung lediglich der aktiven Schicht 6 wird auch als P2-Strukturierung bezeichnet und erfolgt in einem P2-Strukturierungsschritt P2. Die P2-Strukturierung dient der Durchbrechung der aktiven Schicht 6 zwecks Kontaktierung der beiden Elektroden 4, 8. Die aktive Schicht 6 wird vorliegend an den Kontaktstellen 42 mit einem Laser strukturiert, analog zur P1*-Strukturierung. Vorliegend erfolgt die P2-Strukturierung auch gemeinsam mit der P1*-Strukturierung im zweiten Schritt S2, sodass der P1*-Strukturierungsschritt P1* und der P2-Strukturierungsschritt P2 in einem gemeinsamen Strukturierungsschritt zusammengefasst sind, nämlich dem zweiten Schritt S2, und mittels derselben Strukturierungseinheit 54 der Anlage 16 durchgeführt werden. Die Strukturierung der aktiven Schicht 6 an den Kontaktstellen 42 erfolgt dann gemeinsam mit der Strukturierung der unteren Elektrode 4 (an den Trennstellen 22) in einem einzelnen Strukturierungsschritt S2.

Optional wird durch die Strukturierung der aktiven Schicht 6 an einer jeweiligen Kontaktstelle 42 als Unterbrechung 50 ein Kanal ausgebildet, welcher derart dimensioniert ist, dass die Tinte 32, aus welcher die Durchkontaktierungen 44 hergestellt werden, mittels Kapillareffekt in den Kanal einzieht. Die Unterbrechung 50 (d.h. der Kanal) weist wie die Unterbrechung 24 eine Breite b2 von z.B. maximal 20 µm auf.

Eine P2-Strukturierung ist jedoch nicht zwingend erforderlich und entsprechend wird in einer zweiten, nicht explizit gezeigten Ausgestaltung auf eine P2-Strukturierung verzichtet. Entsprechend werden nicht wie in Fig. 3 mit einem Laser Unterbrechungen 50 erzeugt, sondern stattdessen werden die Durchkontaktierungen 44 an den Kontaktstellen 42 in die aktive Schicht 6 hinein gedruckt, nämlich mittels einer Tinte 32, welche die aktive Schicht 6 auflöst oder verdrängt. Im Gegensatz zur P2-Strukturierung wird demnach die aktive Schicht 6 an den Kontaktstellen 42 nicht vor der Ausbildung der Durchkontaktierungen 44 und separat hierzu entfernt, sondern die Durchkontaktierungen 44 werden derart in die aktive Schicht 6 hinein gedruckt, dass diese exakt an den Kontaktstellen 42 durch die Tinte 32 verdrängt oder aufgelöst wird. Zum Auflösen der aktiven Schicht 6 weist die Tinte 32 ein entsprechend geeignetes Lösungsmittel auf.

Die Kontaktstellen 42 und die Trennstellen 22 sind im gezeigten Ausführungsbeispiel räumlich voneinander getrennt, d.h. die Unterbrechungen 24 an den Trennstellen 22 werden räumlich getrennt von den Durchkontaktierungen 44 und gegebenenfalls den Unterbrechungen 50 and den Kontaktstellen 42 ausgebildet. Entsprechend grenzen die Kontaktstellen 42 und die Trennstellen 22 nicht unmittelbar aneinander an, sondern sind voneinander beabstandet, z.B. derart, dass zwischen je einer Kontaktstelle 42 und einer Trennstelle 22 eine Insel 52 der aktiven Schicht 6 verbleibt. Dadurch liegt zwischen Kontaktstellen 42 und Trennstellen 22 ein Abstand x vor.

Vorliegend wird die aktive Schicht 6 zusätzlich strukturiert, indem diese an Teilunterbrechungsstellen 58 lediglich teilweise durchbrochen wird, d.h. dass zumindest eine der Einzelschichten 6a, 6b durchbrochen wird, eine andere der Einzelschichten 6a, 6b jedoch nicht, d.h. intakt bleibt. Eine solche Strukturierung, bei welcher die aktive Schicht 6 an Teilunterbrechungsstellen 58 lediglich teilweise durchbrochen wird, wird auch als P3-Strukturierung bezeichnet, welche entsprechend in einem P3-Strukturierungsschritt P3 erfolgt. Dieser wird vorliegend ebenfalls mit der Strukturierungseinheit 54 durchgeführt, alternativ mit einer separaten Strukturierungseinheit.

Vorliegend wird jegliche Strukturierung (P1*-, P2-, P3-Strukturierung) durchgeführt und fertiggestellt wird, bevor das Sperrmaterial 28 und die obere Elektrode 8 aufgedruckt werden, die Strukturierungseinheit 54 ist also in Förderrichtung F stromauf der Druckeinheit 38 angeordnet.

In dem hier gezeigten Ausführungsbeispiel werden die Durchkontaktierungen 44 oder allgemein wenigstens eine weitere Leiterstruktur gemeinsam mit der oberen Elektrode 8 aufgedruckt und aus der gleichen Tinte 32 hergestellt und gemeinsam in einem einzelnen Druckschritt, hier dem vierten Schritt S4. Die Durchkontaktierungen 44 und alternativ oder zusätzlich auch andere Leiterstrukturen (z.B. Sammelleiter) und die obere Elektrode 8 werden demnach mit derselben Druckeinheit 38 hergestellt, sogar mit demselben Druckkopf 36 dieser Druckeinheit 38. Die Durchkontaktierungen 44 und die obere Elektrode 8 werden dann im gleichen Verfahrensschritt aufgedruckt, nämlich dem bereits genannten vierten Schritt S4. Dabei werden die obere Elektrode 8 und die Durchkontaktierungen 44 nicht separat voneinander in unterschiedlichen Teilschritten aufgedruckt, sondern tatsächlich als eine einzelne, monolithische Struktur. Entsprechend werden die Durchkontaktierungen 44 und die obere Elektrode 8 auch gemeinsam ausgehärtet. Zum Aufdrucken der oberen Elektrode 8 und der Durchkontaktierungen 44 wird vorliegend auch derselbe Farbkanal verwendet.

Zur Ausbildung der Durchkontaktierungen 44 wird die Tinte 43 an den Kontaktstellen 42 außerdem mit größerer Schichtdicke d5 aufgedruckt, als außerhalb der Kontaktstellen 42. Dadurch wird sichergestellt, dass an den Kontaktstellen 42 hinreichend viel Material aufgetragen wird, um eine funktionierende Durchkontaktierung 44 auszubilden. Zum Aufdrucken der Tinte 32 mit unterschiedlicher Schichtdicke d5 wird vorliegend ein Graustufendruck verwendet. Damit lassen sich die obere Elektrode 8 und die Durchkontaktierungen 44 mittels eines einzelnen Farbkanals der Druckeinheit 38 der Anlage 16 herstellen. Dabei wird ausgenutzt, dass beim Aufdrucken der Tinte 32 die aufgedruckte Menge über einen Grauwert einstellbar ist, welcher in der Bilddatei 34 speicherbar ist.

Die in Fig. 6 gezeigte Anlage 16 ist als einzelne Maschine konzipiert, bei welcher sowohl die Strukturierungsschritte P1 *, P2, P3 als auch die Druckschritte S3, S4 inline und ohne Zwischenlagerung oder Unterbrechung erfolgen. Grundsätzlich geeignet ist aber auch eine nicht gezeigte Alternative, bei welcher die Anlage 16 zwei Maschinen aufweist, welche grundsätzlich unabhängig voneinander betrieben werden und von welchen die eine Maschine lediglich die Strukturierungsschritte P1 *, P2, P3 durchführt (Strukturierungsmaschine) und die andere Maschine lediglich die Druckschritte S3, S4 (Druckmaschine).

### Bezugszeichenliste

- 2: Halbleiterelement
- 4: untere Elektrode
- 6: aktive Schicht
- 6a: Einzelschicht (Lochleitungsschicht)
- 6b: Einzelschicht
- 8: obere Elektrode
- 10: Substrat
- 12: Zelle
- 14: Halbzeug
- 16: Anlage
- 22: Trennstelle
- 24: Unterbrechung (der unteren Elektrode und der aktiven Schicht)
- 26: untere Teilelektrode
- 28: Sperrmaterial
- 30: Tinte (Sperrmaterial)
- 32: Tinte (Material für die obere Elektrode und die Durchkontaktierungen)
- 34: Bilddaten
- 36: Druckkopf
- 38: Druckeinheit
- 40: erste Aushärteeinheit
- 42: Kontaktstelle
- 44: Durchkontaktierung
- 48: obere Teilelektrode
- 50: Unterbrechung (lediglich der aktiven Schicht)
- 52: Insel
- 54: Strukturierungseinheit
- 56: zweite Aushärteeinheit
- 58: Teilunterbrechungsstelle
- A1: erster Aushärteschritt
- A2: zweiter Aushärteschritt
- b1: Breite (der Unterbrechung 24)
- b2: Breite (der Unterbrechung 50)
- d1: Schichtdicke (der unteren Elektrode)
- d2: Schichtdicke (des Substrats)
- d3: Schichtdicke (der aktiven Schicht)
- d4: Schichtdicke (des Sperrmaterials)
- d5: Schichtdicke (der oberen Elektrode)
- F: Förderrichtung
- P1*: P1*-Strukturierungsschritt (P1*-Strukturierung)
- P2: P2-Strukturierungsschritt (P2-Strukturierung)
- P3: P3-Strukturierungsschritt (P3-Strukturierung)
- S1: erster Schritt (Bereitstellung des Halbzeugs)
- S2: zweiter Schritt (Strukturierungsschritt)
- S3: dritter Schritt (erster Druckschritt)
- S4: vierter Schritt (zweiter Druckschritt)
- x: Abstand

## Patentansprüche

1. Verfahren zur Herstellung eines Halbleiterelements (2), welches eine untere Elektrode (4), eine aktive Schicht (6) und eine obere Elektrode (8) aufweist,
- wobei ein Halbzeug (14) bereitgestellt wird, welches die untere Elektrode (4) aufweist sowie die aktive Schicht (6), welche auf die untere Elektrode (4) aufgetragen ist,
- wobei ein oder mehrere Positionen für Trennstellen (22) vorgegeben sind oder werden,
- wobei die untere Elektrode (4) durch die aktive Schicht (6) hindurch strukturiert wird und dabei an den Positionen für die Trennstellen (22) jeweils eine Unterbrechung (24) als Trennstelle (22) ausgebildet wird, welche die untere Elektrode (4) in mehrere untere Teilelektroden (26) unterteilt,
- wobei an den Positionen für die Trennstellen (22) ein Sperrmaterial (28) aufgedruckt wird, um eine Kontaktierung der unteren Elektrode (4) mit der oberen Elektrode (8) an den Trennstellen (22) zu verhindern,
- wobei die obere Elektrode (8) auf die aktive Schicht (6) aufgedruckt wird.

2. Verfahren nach Anspruch 1,
wobei das Sperrmaterial (28) und die obere Elektrode (8) jeweils mittels eines Digitaldruckverfahrens, insbesondere Inkjet-Druckverfahrens, aufgedruckt werden.

3. Verfahren nach Anspruch 1 oder 2,
wobei das Sperrmaterial (28) derart eingefärbt ist oder wird, dass dessen Farbe an eine Farbe der aktiven Schicht (6) angeglichen ist.

4. Verfahren nach einem der Ansprüche 1 bis 3,
wobei an einer oder mehreren Kontaktstellen (42) jeweils eine Durchkontaktierung (44) aufgedruckt wird, welche durch die aktive Schicht (6) hindurchreicht und welche die obere Elektrode (8) mit der unteren Elektrode (4) elektrisch leitend verbindet.

5. Verfahren nach Anspruch 4,
wobei, bevor die Durchkontaktierungen (44) aufgedruckt werden, die aktive Schicht (6) an den Kontaktstellen (42) strukturiert wird, sodass an einer jeweiligen Kontaktstelle (42) die untere Elektrode (4) freigelegt wird.

6. Verfahren nach Anspruch 5,
wobei
- die Strukturierung (P1*) der aktiven Schicht (6) an den Kontaktstellen (42),
- die Strukturierung (P2) der unteren Elektrode (4), und
- eine zusätzliche Strukturierung (P3) der aktiven Schicht (6), bei welcher diese an Teilunterbrechungsstellen lediglich teilweise unterbrochen wird,
gemeinsam in einem einzelnen Strukturierungsschritt erfolgen.

7. Verfahren nach Anspruch 5 oder 6,
wobei jegliche Strukturierung durchgeführt und fertiggestellt wird, bevor das Sperrmaterial (28) und die obere Elektrode (8) aufgedruckt werden.

8. Verfahren nach einem der Ansprüche 5 bis 7,
wobei durch die Strukturierung der aktiven Schicht (6) an einer jeweiligen Kontaktstelle (42) ein Kanal ausgebildet wird, welcher derart dimensioniert ist, dass eine Tinte (32), aus welcher die Durchkontaktierungen (44) hergestellt werden, mittels Kapillareffekt in den Kanal einzieht.

9. Verfahren nach Anspruch 4,
wobei die Durchkontaktierungen (44) an den Kontaktstellen (42) in die aktive Schicht (6) hinein gedruckt werden, nämlich mittels einer Tinte (32), welche die aktive Schicht (6) auflöst oder verdrängt.

10. Verfahren nach einem der Ansprüche 4 bis 9,
wobei die Kontaktstellen (42) und die Trennstellen (22) räumlich voneinander getrennt ausgebildet werden.

11. Verfahren nach einem der Ansprüche 4 bis 10,
wobei die Durchkontaktierungen (44) gemeinsam mit der oberen Elektrode (8) aufgedruckt und aus der gleichen Tinte (32) hergestellt werden und gemeinsam in einem einzelnen Druckschritt.

12. Verfahren nach einem der Ansprüche 1 bis 11,
wobei die obere Elektrode (8) gemeinsam mit wenigstens einer weiteren Leiterstruktur aufgedruckt wird, für welche eine andere Leitfähigkeit vorgegeben ist als für die obere Elektrode (8),
wobei die obere Elektrode (8) und die wenigstens eine weitere Leitstruktur dadurch mit unterschiedlicher Leitfähigkeit hergestellt werden, dass ein Graustufendruck verwendet wird.

13. Verfahren nach einem der Ansprüche 1 bis 12,
wobei das Halbleiterelement (2) ein organisches Photovoltaikelement ist und/oder ein Dünnschicht-Photovoltaikelement.

14. Halbleiterelement (2), welches eine untere Elektrode (4), eine aktive Schicht (6) und eine obere Elektrode (8) aufweist,
- wobei die untere Elektrode (4) und die aktive Schicht (6) strukturiert sind und dadurch eine oder mehrere Trennstellen (22) ausgebildet sind, welche die untere Elektrode (4) in mehrere untere Teilelektroden (26) unterteilen,
- wobei an den Trennstellen (22) ein Sperrmaterial (28) aufgedruckt ist, um eine Kontaktierung der unteren Elektrode (4) mit der oberen Elektrode (8) an den Trennstellen (22) zu verhindern,
- wobei die obere Elektrode (8) auf die aktive Schicht (6) aufgedruckt ist.

15. Anlage, welche ausgebildet ist, ein Verfahren gemäß einem der Ansprüche 1 bis 13 durchzuführen.
